# EUROPÄISCHE PATENTSCHRIFT

(11) **EP 1 269 535 B1**
(45) Veröffentlichungstag und Bekanntmachung des Hinweises auf die Patenterteilung: **10.10.2007**
(21) Anmeldenummer: 01914950.9
(22) Anmeldetag: 04.04.2001
(51) Int. Cl.: H01L 21/78, B23K 26/14, H01L 21/00

(54) **VERFAHREN ZUM SCHNEIDEN EINES GEGENSTANDS UND ZUR WEITERVERARBEITUNG DES SCHNITTGUTS SOWIE TRÄGER ZUM HALTEN DES GEGENSTANDS BZW. DES SCHNITTGUTS**
METHOD FOR CUTTING AN OBJECT AND FOR FURTHER PROCESSING THE CUT MATERIAL AND A CARRIER FOR HOLDING THE OBJECT OR THE CUT MATERIAL
PROCEDE DE COUPE D'UN OBJET ET DE TRAITEMENT ULTERIEUR DU MATERIAU COUPE ET SUPPORT PERMETTANT DE TENIR LEDIT OBJET OU LEDIT MATERIAU COUPE

(30) Priorität: 04.04.2000 CH 666002000
(43) Veröffentlichungstag der Anmeldung: 02.01.2003
(73) Patentinhaber: SYNOVA S.A., 1024 Ecublens (CH)
(72) Erfinder: RICHERZHAGEN, Bernold, CH-1025 Saint-Sulpice (CH)
(74) Vertreter: Roshardt, Werner Alfred
(86) Internationale Anmeldenummer: PCT/CH2001/000218
(87) Internationale Veröffentlichungsnummer: WO 2001/075966

(56) Entgegenhaltungen:
- WO-A-95/32834
- WO-A-99/56907
- US-A- 5 543 365

## Beschreibung

Die Erfindung betrifft ein Verfahren zum Laser-Wasserstrahl-Schneiden eines Gegenstand gemäß Patentanspruch 1 sowie einen beim Verfahren verwendbaren Träger gemäß Patentanspruch 7.

### Stand der Technik

Auf einem Siliziumwafer ist eine Vielzahl von Chips ("Dies") vorhanden, welche während und nach dem Trennprozess als individuelle Chips in ihrer ursprünglichen Lage, insbesondere während weiterer Bearbeitungen und Handlungen gehalten werden mussten. Hierzu wurde vor dem Heraustrennen der Chips der Siliziumwafer auf einen Träger aufgeklebt. Mit einer Säge wurden dann die Chips herausgeschnitten. Zum Herausschneiden wurde die Schnitttiefe einer Diamantscheibe derart eingestellt dass der Wafer voll durchtrennt, der Träger jedoch lediglich angeschnitten wurde. Das bekannte Trennverfahren benötigte eine exakte Einstellung der Schnitttiefe im Mikrometerbereich. Es traten ferner oftmals Ausbrüche an der Ober- und Unterkante der Chips auf Auch konnten Risse entstehen, welche dann zu einem Bruch des Chips führten. Der Verschleiß des Sägeblattes war hoch, und es konnten zudem nur gerade Schnitte ausgeführt werden.

In der US-A 5,543,365 ist ein Verfahren zum Heraustrennen von Chips aus einem Wafer beschrieben. Bei dem Heraustrennen sollen sich in die Chips ausbreitende Risse unterdrückt werden. Hierzu wird vorgängig im Bereich der zu erzeugenden Trennfuge das Silizium des Wafers in Polysilicon durch eine aus der Metallurgie bekannte Wärmebehandlung umgewandelt Diese Umwandlung erfolgt dadurch, dass mittels eines Laserstrahls die Trennfurche aufgewärmt und anschliessend mit einer Wasser- oder Gasspülung abgeschreckt wird, wodurch das durch die Aufwärmung gebildete und Materialrisse unterdrückende Polysilicon erhalten bleibt. Nach dem Abschrecken wird vorzugsweise durch Sägen entlang der Polysiliconurnwandlungslinien mit einer Säge eine Vereinzelung der Chips vorgenommen.

Anstelle einer Säge verwendet die US-A 5,543,365 auch einen an der Waferunterseite angreifenden ersten und einen an der Waferoberseite angreifenden zweiten Laserstrahl. Der Fokus des Laserstrahls wird auf die Waferoberfläche oder in den Wafer hinein gelegt. Es wird hierbei sowohl auf der Waferober- wie auf der-unterseite Polysilicon, wie oben erwähnt, erzeugt. Der an der Waferunterseite angreifende Laserstrahl vollbringt eine Abtragung von 50% bis 95% des Furchenmaterials; der auf der Oberseite angreifende Laser durchtrennt dann den geringen Rest.

Der Wafer kann zum Schneiden mit einer Säge durch eine auf der oberen Oberfläche des Wafers aufgebrachte als "tape" bezeichnete Klebefolie in einem flexiblen Rahmen gehalten werden.

### Aufgabe der Erfindung

Aufgabe der Erfindung ist es, ein Verfahren sowie einen Träger für einen mit einem Laser-Wasserstrahl zu bearbeitenden (zu schneidenden) Gegenstand zu schaffen, welches bzw. welcher es gestattet, den Gegenstand vor, während und nach einem Schnittvorgang lagefixiert auch für nachfolgende Bearbeitungshandlungen des (von einander durch den Schnitt getrennten) Schnittguts in der ursprünglichen Lage zu halten. Eine weitere, die erste Aufgabe einschließende Aufgabe der Erfindung ist es, den Gegenstand als Ganzes zu bearbeiten (vorzugsweise zu dünnen) und ohne neue Fixierung anschließend zu schneiden; auch sollen ein oder mehrere Wafer einwandfrei trennbar und deren Schnittgut (Chips; Dies) ebenfalls für eine nachfolgende Behandlung sicher in ihrer ursprünglichen Lage fixierbar sein.

### Lösung der Aufgabe

Die erste Aufgabe wird dadurch gelöst, dass der Gegenstand auf einem Träger mit einem Klebemittel fixiert wird, durch das auch eine Fixierung nach dem Trennen des Schnittgutes für eine folgende Weiterver- bzw. -bearbeitung beibehalten wird. Zum Trennen wird erfindungsgemäß ein Laser-Wasserstrahl verwendet.

Der Träger kann nun für die Laserstrahlung transparent oder nicht transparent ausgebildet sein. Wird ein nicht transparenter Träger verwendet, so wird dieser von der Laserstrahlung angegriffen. Man wird jedoch die Laserintensität derart wählen, dass nur ein geringfügiger Materialabtrag vom Träger erfolgt. Beim Schnitt wird sich dann eine kleine Schnittnut ergeben. Diese Schnittnut hält jedoch Wasser davon ab, zwischen den Träger und das Schnittgut zu gelangen.

Als nicht transparentes Material haben sich insbesondere Siliziumplatten bewährt, da diese in guter ebener Qualität zu günstigen Preisen erhältlich sind.

Wird ein Träger aus für die Laserstrahlung transparentem Material gewählt, wird er durch die Laserstrahlung nicht angegriffen, d.h. nicht abgetragen und nicht durchtrennt. Wird als Gegenstand ein Wafer verwendet, so bleiben die durch Trennung erzeugten Chips (Dies; Schnittgut) lagefixiert für eine weitere Bearbeitung. Wird zudem ein für eine Flüssigkeit, insbesondere Wasser durchdringbares Material beim Träger verwendet, dringt auch hier die Flüssigkeit nicht unter das geschnittene, aber noch aufgeklebte Gut.

Anstatt den aufgeklebten Gegenstand nur zu schneiden, kann er auch vor dem Schneiden als Ganzes bearbeitet werden, wobei er allerdings dann schon auf den Träger aufgeklebt ist. Wird die Erfindung auf die Herstellung von Chips auf Wafern angewandt, so kann der ganze Wafer vor dem Schneiden dünn geschliffen werden. Nach dem Schleifen wird der dünne Wafer dann mit dem Laser-Wasserstrahl entsprechend der gewünschten Konturen in eine Vielzahl von Chips zerschnitten, welche auch nach dem Schnitt auf dem Träger infolge ihrer Klebung lagefixiert sind. Eine Ausrichtung der zu führenden Schnitte kann mittels diverser Verfahren erfolgen. Es können Lagemarken durch vorgängig erzeugte Bohrungen oder Einschnitte erzeugt werden. Es kann aber auch die Lage der Schnitte durch Bilderkennungsmaßnahmen ermittelt werden. Handelt es sich um Halbleiter- oder optische Chips, so wird man diese, d. h. den ungeschnittenen und noch nicht in der Dicke reduzierten Wafer auf der aktiven Oberfläche aufkleben und dann die Rückseite bearbeiten. Auch wird man von der Rückseite aus schneiden. Eine Lageerkennung ist in diesem Fall dann über eine Infrarot-Kamera möglich, sofern das Material des Trägers (z.B. Silizium) in diesem Wellenlängenbereich transparent ist.

Wird vorzugsweise als Träger eine insbesondere flexible, bevorzugt dehnbare Matte (Tissue) verwendet, so kann durch Dehnen der Abstand der Chips gegeneinander derart vergrößert werden, dass deren gegenseitiges Berühren bei der Entnahme vom Träger unmöglich wird.

Die Matte kann nun aus einem gewebten (woven) oder aus einem ungewebten (non-woven) Fasermaterial bestehen. Das ungewebte Fasermaterial ist bedeutend billiger als das gewebte, jedoch ist seine Dichte, insbesondere in Bezug auf ein Durchdringen des Wassers des Laser-Wasserstrahls inhomogen.

Neben der optischen Eigenschaft der Transparenz für die verwendete Laserstrahlung sind außer einer Wasserdurchlässigkeit die restlichen mechanischen Eigenschaften von untergeordneter Bedeutung. Typischerweise wird man Fasern mit einem Faserdurchmesser von etwa 5 µm bis 100 µm, vorzugsweise von 5 µ bis 50 µm und einem Faserabstand von 0 bis 500 µm, insbesondere von 0 bis 150 µm, vorzugsweise von 0 bis 50 µm verwenden.

Das Wasser der Wasserstrahls drückt die Fasern leicht zur Seite, um die Matte zu durchdringen. Das sich am Auftreffort des Laser-Wasserstrahls nach Durchdringen des zu trennenden Gegenstands befindliche Klebemittel wird je nach verwendetem Material mehr oder weniger ausgewaschen. Der Chip bleibt jedoch immer je nach verwendetem Verfahren mit seiner Unterseite bzw. Oberseite (aktive Seite ) auf der Matte haften.

Es kann jedoch auch ein Kleber gewählt werden, der gar nicht oder nur geringfügig ausgewaschen wird. Der Wasserstrahl drückt nämlich, wie oben angedeutet, die Fasern der Matte auseinander. Das Wasser kann somit durch die Matte auch bei ganz oder teilweise verbleibendem Klebemittel hindurchdringen. Wird das Klebemittel nicht oder nur etwas ausgewaschen, kann die Durchtrittsbahn (Schnittverlängerung) entlang des Laser-Wasserstrahl-Schnittes je nach verwendetem Klebemittel wieder "verkleben". Soll die Matte mit den getrennten Chips durch einen sogenannten Vakuumhalter gehalten werden, während ein einzelner Chip durch Nadeln nach oben gedrückt wird, so unterstützen die wieder verklebten "Durchtrittslinien" die Saugkraft des Vakuumhalters durch eine ausreichende "Luftdichtigkeit". Das Wieder-Verkleben ist jedoch von untergeordneter Bedeutung, da die Durchtrittsbahnen mit ihrer geringen Fläche im Verhältnis zur restlichen Fläche, auf die der Saughalter angreift, nahezu nicht ins Gewicht fallen.

Da die Matte flexibel ist, können die Chips durch durch die Matte hindurchstechende bzw. gegen die Mattenrückseite drückende Nadeln ausgeworfen und mit einem Vakuumgreifer gegriffen werden (pick and place).

Anstelle einer flexiblen Matte kann auch eine transparente Platte als Träger verwendet werden. Der Laserstrahl durchdringt nun die Platte, ohne diese zu bearbeiten. Das Wasser verläßt den Schnittspalt in dessen Schnittrichtung. Dieses Verfahren eignet sich besonders für sehr dünne, d.h. zerbrechliche Chips bzw. Wafer. Durch die transparente Platte hindurch kann auch noch eine Kennzeichnung der Chips durch eine Laserstrahlung (Lasermarkierung) an deren Rückseite vorgenommen werden. Da die Trägerplatte nicht angegriffen wird, kann sie immer wieder verwendet werden. Infolge dieser Lasermarkierung ist eine Verfolgung der einzelnen Chips während der nachfolgenden Bearbeitung möglich.

Wird jedoch statt einer kompakten Platte eine poröse (z.B. eine gesinterte oder fotochemisch behandelte Glasplatte) verwendet, wie unten beschrieben, so kann das Wasser auch durch diese Platte hindurch abfließen.

Zusammenfassend kann gesagt werden, dass als Träger für zu schneidendes Gut je nach besonderem Anwendungszweck
eine "Matte" verwendet werden kann, welche
◆ transparent für die schneidende Laserstrahlung des Laser-Wasserstahls ist,
◆ wasserdurchlässig,
◆ dehnbar oder auch nicht dehnbar
◆ gewebt oder auch nicht gewebt ist und aus
◆ Polyäthylen,
◆ Polypropylen,
◆ PET oder
◆ Polyurethan, ... bestehen kann.

Es kann aber auch abgestimmt auf die Anwendung ein fester Träger eingesetzt werden, der
◆ nicht dehnbar,
◆ transparent oder nicht transparent,
◆ nicht wasserdurchlässig oder wasserdurchlässig ist und aus
◆ Glas,
◆ Quarz oder
◆ Silizium, ... besteht.

Eine Haftung zwischen dem zu schneidenden Gut (z.B. Wafer) und der Träger erfolgt durch
◆ einen UV-Kleber,
◆ Vakuum,
◆ einen thermischen Kleber,
◆ Wachs, ...

Das zu schneidende Gut kann nun je nach gewählter Anwendung mit seiner
◆ aktiven (Möglichkeit des "Dünnens" schon auf dem Träger)
◆ oder passiven Seite
auf den Träger geklebt werden.

### Ausführungsbeispiele der Erfindung

Im folgenden werden Beispiele des erfindungsgemäßen Trägers sowie des erfindungsgemäßen Laser-Wasserstrahl-Schneidens anhand der Zeichnungen an mehreren Beispielen näher erläutert. Es zeigen:
- Fig. 1: einen Querschnitt durch einen mattenartigen Träger mit aufgeklebtem Gegenstand,
- Fig. 2: analog hierzu einen Querschnitt mit einem plattenförmigen festen Träger und
- Fig. 3: eine Variante zu dem in den **Figuren 1** und **2** dargestellten Verfahren.

### Wege zur Ausführung der Erfindung

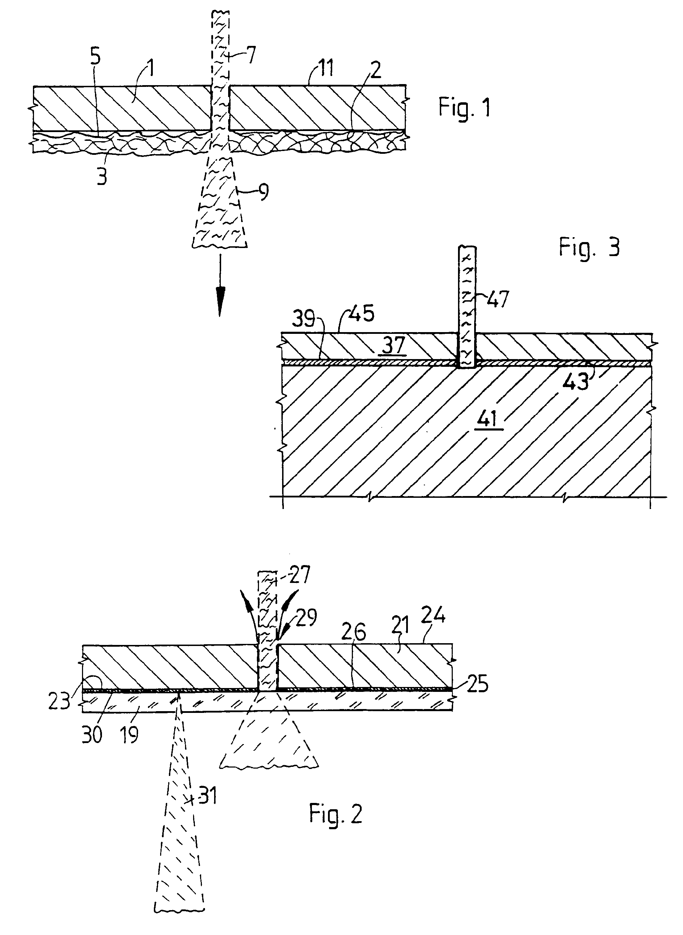

In **Figur 1** ist ein Silizium-Wafer 1 mit seiner Unterseite **2** auf einer Matte **3** aufgeklebt im Querschnitt dargestellt. Die "aktive" Oberseite **11** des Wafers **1** liegt oben frei. Die Matte **3** besteht aus mit Klebemittel überzogenem bzw. getränktem Fasermaterial. Da es sich um ein Fasermaterial handelt, ist die Oberfläche **5** der Matte **3** unregelmäßig dargestellt. Es ist jedoch zu beachten, dass es sich hier um eine starke Vergrößerung handelt. Ein den Wafer **1** durchtrennender Laser-Wasserstrahl **7** hat nämlich typischerweise einen Durchmesser von lediglich 50 µm. Nach Durchdringen der Matte **3,** wobei der Wasserstrahl **7** das Fasermaterial der Matte **3** zur Seite drückt, erfolgt eine starke Aufweitung **9,** d.h. Versprühen des Wasserstrahls.

Die Erzeugung eines hierzu zu verwendenden Laser-Wasserstrahls ist beispielsweise in der EP-A 0 762 947 und der WO 99/56907 beschrieben.

Die Matte 3 kann aus gewebtem (woven) oder nicht gewebtem (non-woven) Fasermaterial (Tissue) bestehen. Die Fasern des Gewebes sind typischerweise 20 µm dick. Sie können jedoch auch dicker und auch dünner gewählt werden. Wichtig ist nur, dass das Fasermaterial keine nennenswerte Absorption für die Laserstrahlung aufweist, damit keine Materialabtragung und damit keine Zerstörung der Matte **3** durch die Laserstrahlung eintritt. Das Fasermaterial sollte auch eine gewisse Hitzebeständigkeit aufweisen, damit es nicht durch die aus dem Trennschnitt austretende Schmelze des Wafermaterials beschädigt wird. Als Fasermaterial kann, sofern mit der Strahlung eines Neodym-Lasers bei 1,06 µm Wellenlänge gearbeitet wird, beispielsweise Polyurethan, Polypropylen, ... verwendet werden. Auch soll das Fasermaterial nicht zu dicht sein, um eine Porosität beim Durchdringen des Wasserstrahls zu erreichen. Aufgrund der Porosität ist die Matte dehnbar, so dass nach Durchtrennen des Wafers **3** der Abstand der Chips durch Dehnen der Matte erhöht werden kann. Hierdurch ist sichergestellt, dass die Chips bei der späteren Entnahme sich nicht berühren. Die Matte **3** hat eine Dicke im Bereich von 10 µm bis 500 µm, bevorzugt von 10 µm bis 100 µm: d.h. man könnte sie auch als "poröse" Folie bezeichnen.

Bevorzugt wird die Matte 3 seitlich unter einer vorgegebenen Spannung gehalten. Die Matte kann jedoch auch, um ein Durchhängen zu vermeiden, durch unterlegte Stützen unterstützt werden. Die Stützen können äußerst dünn, z.B. als gespannte Drähte ausgebildet sein. Bevorzugt wird man aber die Stütze bzw. Stützen transparent ausbilden, um einen Materialabtrag durch die durch die Matte hindurchdringende Laserstrahlung zu vermeiden. Als besonders vorteilhaft haben sich für Wasser poröse Streben erwiesen. Die Strebe nimmt dann das Wasser auf und wirft es nicht zurück, wodurch der Wafer eben bleibt. Als Strebenmaterial kann offenporiges Glas oder Glasschaum verwendet werden. Auch kann Keramik bzw. Keramikschaum eingesetzt werden. Gute Ergebnisse sind ferner mit gesinterten Glaskugeln und fotostrukturiertem Glas erreicht worden.

Als Klebemittel verwendet man bevorzugt einen Acryl-, UV-, thermoplastischen Kleber usw.

Zum Heraustrennen von Chips aus einem Wafer **1** wird dieser auf den mit einer Matte **3** bestückten Arbeitsplatz gelegt. Der Wafer **1** kann leicht angedrückt bzw. mit Vakuum angezogen werden. Er ist dann unverrückbar auf der mit einem Klebemittel versehenen Matte **3** gehalten. Der Laser-Wasserstrahl **7** wird nun entsprechend der Lage der herauszutrennen Chips über die Waferoberfläche **7** verfahren. Der Wafer **1** wird durchtrennt, wobei der Wasserstrahl einmal zur Führung des Laserstrahls dient und gleichzeitig die Schnittkanten kühlt. Nach dem Durchtritt durch den Wafer **1** "zwängt" sich dann der Wasserstrahl durch das Fasermaterial und versprüht.

Je nach verwendetem Klebemittel wird dieses durch den Wasserstrahl mehr oder weniger ausgespült. Sollen nachfolgend Chips mit einem Vakuumgreifer entnommen werden, so wird die Matte nach dem Schneiden mit einem Vakuumhalter gehalten, lediglich am Ort des zu entnehmenden Chips wird dieser durch Nadeln im Vakuumhalter, welche an der Mattenrückseite angreifen, angehoben. Der Vakuumhalter arbeitet als sogenannter Niederhalter.

Wie bereits eingangs angedeutet, kann ein Klebemittel verwendet werden, welches nachträglich wieder in den Schnitt einwandernd diesen "luftdicht" verklebt. Hierdurch wird die Saugleistung des Vakuumhalters etwas vergrößert. Die Vergrößerung ist jedoch unbedeutend, da der mit dem Laser-Wasserstrahl erzeugte Schnitt im Bereich von 50 µm sehr schmal ist. D.h. mit Blick auf die gesamte Fläche machen die Schnitte nur etwa 2% bis 5% aus.

Anstelle einer mehr oder weniger flexiblen Matte **3** kann jedoch auch eine für die Laserstrahlung transparente Festkörperplatte **19** als Träger, wie in Figur 2 dargestellt, verwendet werden. Wird die Strahlung eines Neodym-Lasers (1,06 µm) verwendet, kann als Plattenmaterial beispielsweise Quarz verwendet werden. Bevorzugt erhält die Platte **19** auf ihrer dem abzulegenden, später zu durchtrennenden Wafer **21** benachbarten Oberfläche eine Mikrostruktur, auf die dann das Klebemittel **25,** analog zu den bereits oben erwähnten aufgebracht wird, so dass das Klebemittel immer gut auf der Platte hält, aber nicht auf der Unterseite der Chips übergeht, sondern nur zu dieser eine klebende Haltewirkung hat. Auch hier ist der Wafer mit seiner Unterseite **26** (nicht "aktive" Oberfläche) aufgeklebt. Seine "aktive" Oberseite **24** ist frei.

Beim Laser-Wasserstrahl-Schneiden durchschneidet jetzt der Strahl **27** den Wafer **21.** Der Laserstrahl transmittiert die Platte **19** ohne diese abzutragen. Das Wasser des Laser-Wasserstrahls **27** geht bei der kompakten Platte 19 in Richtung des Schnitts **29** weg. Der Schnitt **29** hat eine typische Breite von etwa 50 µm und kleiner.

Die Platte **19** als fester Träger kann nicht gedehnt werden. Beim Entnahmeverfahren der Chips muss nun derart exakt gearbeitet werden, dass sich die Chips nicht berühren. Da hier eine sehr hohe Lagegenauigkeit auch nach dem Trennen existiert, können die Chips noch aufgeklebt auf dem Träger außerdem getestet werden.

Es kann mit einem weiteren, auf die Chiprückseite **30** fokussierten Laserstrahl 31 eine Kennzeichnung (Beschriftung) der Chips vorgenommen werden. Diese Kennzeichnung gestattet eine Identifizierung des Chips im gesamten Bearbeitungsvorgang. Die auch für die Beschriftungsstrahlung transparente Trägerplatte muss nicht planparallel ausgebildet sein, da für die Beschriftungsstrahlung in der Regel eine große Fokuslänge verwendet wird.

Die Verwendung eines transparenten Festkörpers als Träger ist überall dort angezeigt, wo es sich um zerbrechliche dünne Wafer handelt.

Die Platte **19** kann nun eine kompakte transparente Platte sein, wie sie beispielsweise aus einer Schmelze hergestellt wird. Sie kann aber auch eine gesinterte, insbesondere poröse Platte sein. Eine poröse Platte hat zudem den Vorteil, dass das Wasser des Laser-Wasserstrahls durch sie abfließen kann. Die Platte kann somit aus offenporigem Glas oder Glasschaum, aus Keramik bzw. Keramikschaum, aus gesinterten Glaskugeln, aus fotostrukturiertem Glas, ... bestehen.

Im Laser-Wasserstrahl wird der die für den Trennschnitt notwendige Energie tragende Laserstrahl in einem Wasserstrahl geführt. Anstelle von Wasser kann jedoch auch eine andere für die Laserstrahlung transparente Flüssigkeit verwendet werden. Wasser hat sich jedoch bewährt, da es preisgünstig ist und eine große Wärmekapazität hat.

Anstelle eines Siliziumwafers können mit den oben beschriebenen Trägern auch andere Gegenstände zum Laser-Wasserstrahl-Schneiden gehalten werden. Es können z.B. Wafer aus Germanium, GaAs, Siliziumkarbid usw. in Plattenform bearbeitet werden. Anstelle einer Plattenform können auch andere kleine Teile mit variabler Größe gehalten und bearbeitet werden.

Wird beispielsweise ein Klebemittel mit variabler Klebekraft eingesetzt, so kann die Klebekraft zum Ergreifen mit dem Vakuumgreifer herunter gesetzt werden. Ein derartiges Klebemittel ist beispielsweise ein sogenannter UV-Kleber. Durch eine Bestrahlung mit einer UV-Strahlung wird dessen Klebekraft herabgesetzt. Eine Bestrahlung würde man dann im Zeitpunkt des Ergreifens eines Chips mit dem Vakuumgreifer zur Reduzierung der Haltekraft vornehmen.

Die Bearbeitung von dünnen Wafern (dünner als 300 µm, vorzugsweise dünner als 100 µm) erfordert in der Chipherstellung eine große Sorgfalt. Das Handling, besonders der dünnen Wafer ist schwierig. Diese Wafer biegen sich nämlich "wie Papier' und hängen durch. Sie brechen leicht beim Handling. Auch können sie hierbei einem mechanischen Stress ausgesetzt sein, der zu einem späteren Bruch der aus dem Wafer herausgeschnittenen Chips führen kann. Das bisher verwendete Sägen mit Diamantscheiben im Gegensatz zum erfindungsgemäßen Verfahren, wie oben und nachfolgend in einer weiteren Variante angeführt, ließ zudem oftmals Kantenausbrüche und Risse entstehen.

Bekanntermaßen wurden die noch "dicken" Wafer mit einer Dicke von beispielsweise 700µm nachdem die Chipstrukturen fertig prozessiert waren, mit der aktiven Seite auf ein sogenanntes "Grindung Tape" geklebt und dann ausgehend von der Waferrückseite dünn geschliffen. Es wurde hierbei mechanisch, nass-chemisch oder trocken-chemisch bearbeitet. Nach dem Schleifen wurde das "Grindung-Tape" entfernt und der nun dünne Wafer auf ein neues sogenanntes "Dicing-Tape" mit seiner gerade geschliffenen Oberfläche aufgeklebt. Die aktive Seite der Chips war nun oben. Große Vorsicht musste hier walten, um ein Brechen des dünnen Wafers auszuschließen.

Aus dem Wafer wurden dann beispielsweise mit einer Diamantsäge, wie bereits oben in der Einleitung beschrieben, die einzelnen Chips heraus gesägt. Durch das herkömmliche Sägen konnten ausgehend von den Schnittkanten Mikrorisse in den Chip hinein sich ausdehnen, was diesen Chip unbrauchbar machte.

Nach dem Sägen wurden die Chips, welche noch auf den "Dicing-Tape" hafteten, einzeln abgenommen und in einem sogenannten "Die-Bonder" weiterverarbeitet.

Als Erfindungsvarante kann nun wie in Figur 3 dargestellt folgendermaßen vorgegangen werden:

Der noch dicke Wafer **37** mit einer beispielsweisen Dicke von 700 µm wird, nachdem die Chipstrukturen fertig prozessiert sind, nun mit der aktiven Seite **39** auf einen Träger **41** aufgeklebt und wie bekannt dünn geschliffen. Als Träger können die bereits oben beschriebenen Materialien verwendet werden; man kann aber beispielsweise auch einen Siliziumwafer als Träger **41** verwenden. Als Kleber **43** können die oben erwähnten Kleber verwendet werden; man kann aber beispielsweise auch Wachs verwenden.

Nach dem der Wafer **37** dünn geschliffen ist (Darstellung in **Figur 3),** werden von der Rückseite **45** des Wafers **37** her die Chips mit einem Laserstrahl bzw. Laser-Wasserstrahl **47** geschnitten. Ein Umklebeh, wie beim herkömmlichen Verfahren ist somit entfallen und damit auch die große Gefahr eines Bruches des dünnen Wafers **37.**

Die Wafer- bzw. Chipoberseite ist jetzt allerdings durch den Träger **41** verdeckt und somit auch durch diesen geschützt. Eine Ausrichtung der vorzunehmenden Schneidbahnen in Bezug auf die Chips wird nun wie folgt vorgenommen: Der Wafer **37** wird mit einer Infrarotkamera von der Rückseite her betrachtet. Der Siliziumwafer ist nämlich im infraroten Spektralbereich transparent (auch ist der Wafer jetzt sehr dünn). Es können ferner bei nicht transparentem Material vor dem Dünnen zum Ausrichten Durchgangslöcher angebracht werden. Anhand der Löcher, die beispielsweise am Rand des Wafers sich genau auf der Mittellinie einer Schneidbahn befinden, kann das Schneidmuster auch von der Rückseite aus ermittelt werden. Auch kann der Wafer kleine sogenannte "Notches" (kleine halbkreisförmige Ausbuchtungen) am Waferrand aufweisen. Die Lage der vorzunehmenden Schneidbahnen relativ zu diesen Notches kann man genau vor dem "Dünnen" bestimmen.

Nach dem Schneiden der Chips wird vorzugsweise die Klebekraft des Klebers herabgesetzt. Eine Klebekraftherabsetzung kann beispielsweise durch Erwärmen des Wachses erfolgen; die Klebekraft anderer Kleber kann z. B. durch Bestrahlen (UV-Bestrahlung) verändert (verringert) werden. Anschließend wird der gesamte Wafer mit seinen geschnittenen Chips mittels eines Vakuumtisches als Ganzes vom Träger abgenommen. Die aktive Seite der Chips ist nun frei und kann von Kleberresten gereinigt werden. Vom Vakuumtisch werden dann die Chips einzeln abgenommen und im "Die-Bonder" weiterverarbeitet.

Vorteil dieses Bearbeitungsverfahrens ist einmal das eliminierte Umkleben. Der Wafer verbleibt auf dem stabilen Träger nach dem "Dünnen" und während des Schneidens der Chips. Es besteht jetzt keine Bruchgefahr mehr.

Als weiterer Vorteil ist anzusehen, dass während des Schneidens die aktive Seite der Chips geschützt ist. Auch werden jetzt keine zusätzlichen Tapes mehr benötigt. Auch ist ein Klebevorgang entfallen (nur noch einer statt deren zwei).

## Patentansprüche

1. Verfahren zum Durchtrennen eines Wafers (1; 21) mit einem Laserstrahl, welcher entsprechend der aus dem Wafer (1; 21) auszuschneidenden Konturen über diesen bewegt wird, wobei der Wafer an einem ein Klebemittel aufweisenden Träger (3: 19) fixiert wird, **dadurch gekennzeichnet, dass** der Laserstrahl in einem Flüssigkeitsstrahl (7; 31) geführt wird, wobei der Wafer unter einer gleichzeitigen Kühlung der Schnittkanten durchtrennt wird, der Träger entweder für den Laserstrahl transparent ausgebildet wird, so dass er nicht abgetragen und nicht durchtrennt wird, oder dass der Träger für den Laserstrahl nicht transparent ausgebildet wird und dabei eine Intensität des Laserstahls derart gewählt wird, dass nur ein geringfügiger Materialabtrag erfolgt, so dass ein noch auf dem Träger (3; 19) klebendes, voneinander durch Schnitte getrenntes Schnittgut (Chips) in der ursprünglichen Lage für bevorzugt unmittelbar nachfolgende Bearbeitungshandlungen zur Verfügung steht.

2. Verfahren nach Anspruch 1, **dadurch gekennzeichnet, dass** als Träger eine Matte (Tissue) mit gewebtem oder nicht gewebtem Fasermaterial verwendet wird.

3. Verfahren nach Anspruch 1 oder 2, **dadurch gekennzeichnet, dass** der Wafer auf dem Träger aufgeklebt und anschließend auf eine vorgegebene Dicke heruntergeschliffen wird, sowie dann das Schnittgut, auf dem Träger kleben bleibend ausgeschnitten wird, wobei eine aktive Schicht des Wafers auf den Träger aufgeklebt ist.

4. Verfahren nach einem der Ansprüche 1 bis 3, **dadurch gekennzeichnet, dass** eine Unterseite des Schnittguts mit einem Beschriftungslaser **gekennzeichnet** wird.

5. Verfahren nach Anspruch 1, **dadurch gekennzeichnet, dass** der Wafer mit mehreren Chips mit seiner der aktiven Seite abgewandten Seite auf dem Träger aufgeklebt wird, der Träger als Platte, insbesondere als planparallele Platte (19) ausgebildet, und vorzugsweise die Platte (19) für die Laserstrahlung transparent ausgebildet ist, um durch diese hindurch das Schnittgut (30) mit dem Laserstrahl zu kennzeichnen.

6. Verfahren nach Anspruch 2, **dadurch gekennzeichnet, dass** der als Matte ausgebildete Träger (3) für eine weitere Schnittgutverarbeitung mit einem Vakuumhalter gehalten wird.

7. Ein Klebemittel aufweisender Träger (3; 19) für das Verfahren nach einem der Ansprüche 1 bis 6 zum Halten eines zu durchtrennenden Wafers bzw. zum Halten des Schnittguts des Wafers vor, während und nach dem Schnittvorgang, **dadurch gekennzeichnet, dass** der Träger (3; 19) derart ausgebildet ist, dass er den Wafer (1;21) bzw. das Schnittgut mit dem Klebemittel fixierend auf ihm liegend trägt, und eine spätere Schnittgutentnahme ermöglicht, wobei der Träger (3; 19) als Matte ausgebildet ist, welche ein betreffend der Laserstrahlung im Flüssigkeitsstrahl (7; 27) transparentes, gewebtes bzw, nicht gewebtes Fasermaterial aufweist.

8. Träger nach Anspruch 7, **dadurch gekennzeichnet, dass** er (3;19) gegen Durchbiegen bzw. Durchhängen gesichert mit wenigstens einer unterlegten, bevorzugt für die Strahlung des Laser-Fiüssigkeitsstrahls transparenten, insbesondere für Wasser als Flüssigkeit des Laser-Flüssigkeitsstrahls durchlässigen, Strebe gehalten ist, wobei das Strebenmaterial ein offenporiges Glas (z.B. eine fotochemisch zur Lochung behandelte Glasplatte), insbesondere ein Glasschaum, bevorzugt eine gesinterte Keramik, vorzugsweise ein gesintertes Glas ist.

9. Träger (3; 19) nach Anspruch 7 oder 8, **dadurch gekennzeichnet, dass** die Matte flexibel mit dehnbarem Fasermaterial ausgebildet ist.

10. Träger (3) nach einem der Ansprüche 7 bis 9, **dadurch gekennzeichnet, dass** die Matte (3) aus einem gewebten (woven) Fasermaterial besteht, wobei das Fasermaterial Polyurethan, bevorzugt Polypropylen, insbesondere Polyäthylen, vorzugsweise PET ist.

11. Träger (3) nach einem der Ansprüche 7 bis 9, **dadurch gekennzeichnet, dass** die Matte (3) aus einem ungewebten (non-woven) Fasermaterial besteht, wobei das Fasermaterial Polyurethan, bevorzugt Polypropylen, insbesondere Polyäthylen, vorzugsweise PET ist.

## Claims

1. Method for separating a wafer (1; 21) with a laser beam, which is moved in accordance with the contours to be cut out of the wafer (1; 21) thereabove, the wafer being fixed to a carrier (3; 19) which has an adhesive means, **characterised in that** the laser beam is guided in a fluid stream (7; 31), the wafer being separated with simultaneous cooling of the cut edges, the carrier either being constructed so as to be transparent with respect to the laser beam so that it is not eroded and is not separated, or the carrier being constructed so as to be non-transparent with respect to the laser beam and an intensity of the laser beam being selected such that only a slight erosion of material is carried out so that there is provided, in the original position for processing operations which preferably follow directly, a cut material (chips) which is still adhesively bonded to the carrier (3; 19) and which is mutually separated by incisions.

2. Method according to claim 1, **characterised in that** a tissue having woven or non-woven fibre material is used as the carrier.

3. Method according to claim 1 or 2, **characterised in that** the wafer is adhesively bonded to the carrier and is subsequently ground to a predetermined thickness and then the cut material is cut out so as to remain adhesively bonded to the carrier, with an active layer of the wafer being adhesively bonded to the carrier.

4. Method according to any one of claims 1 to 3, **characterised in that** a lower side of the cut material is distinguished with an inscription laser.

5. Method according to claim 1, **characterised in that** the wafer is adhesively bonded to the carrier with a plurality of chips with the side thereof facing away from the active side, **in that** the carrier is in the form of a plate, in particular a plane-parallel plate (19), and the plate (19) is preferably constructed so as to be transparent with respect to the laser radiation in order to distinguish the cut material (30) with the laser beam through the plate.

6. Method according to claim 2, **characterised in that** the carrier (3) which is in the form of a tissue is retained with a vacuum retention means for subsequent processing of the cut material.

7. A carrier (3; 19) having adhesive means for the method according to any one of claims 1 to 6 for retaining a wafer to be separated or for retaining the cut material of the wafer before, during and after the cutting operation, **characterised in that** the carrier (3; 19) is constructed in such a manner that it carries the wafer (1; 21) or cut material with the adhesive means being arranged in a fixing manner thereon, and allows subsequent removal of the cut material, the carrier (3; 19) being in the form of a tissue which has a woven or non-woven fibre material which is transparent with respect to the laser radiation in the fluid stream (7; 27).

8. Carrier according to claim 7, **characterised in that** the carrier (3; 19) is retained in a manner secured against bending or sagging with at least one underlaid strut which is preferably transparent with respect to the radiation of the laser fluid stream and which is in particular permeable to water as a fluid of the laser fluid beam, with the strut material being an open-pored glass (for example, a glass plate which is photochemically treated for producing perforations), in particular a glass foam, preferably a sintered ceramic material, preferably a sintered glass.

9. Carrier (3; 19) according to claim 7 or 8, **characterised in that** the tissue is constructed in a flexible manner with expandable fibre material.

10. Carrier (3) according to any one of claims 7 to 9, **characterised in that** the tissue (3) comprises a woven fibre material, the fibre material being polyurethane, preferably polypropylene, in particular polyethylene, preferably PET.

11. Carrier (3) according to any one of claims 7 to 9, **characterised in that** the tissue (3) comprises a non-woven fibre material, the fibre material being polyurethane, preferably polypropylene, in particular polyethylene, preferably PET.

## Revendications

1. Procédé de sectionnement d'une tranche (1 ; 21) à l'aide d'un faisceau laser, lequel est déplacé sur celle-ci selon des contours à découper de la tranche (1 ; 21), la tranche étant fixée sur un support (3 ; 19) présentant un adhésif, **caractérisé en ce que** le faisceau laser est conduit à l'intérieur d'un jet liquide (7 ; 31), la tranche étant découpée avec un refroidissement simultané des arêtes de coupe, soit le support pour le faisceau laser est conçu en étant transparent, de façon à ne pas être usé ni séparé, soit le support pour le laser est conçu en n'étant pas transparent, ce qui permet de sélectionner une intensité du faisceau laser de façon à ce que seule une usure limitée du matériau se produise, afin qu'un objet à couper (puce) adhérant encore au support (3 ; 19), séparé par des coupes soit disponible dans la position initiale pour des manipulations de traitement ayant lieu de préférence immédiatement après.

2. Procédé selon la revendication 1, **caractérisé en ce qu'**une natte (tissu) dotée d'un matériau fibreux tissé ou non tissé est utilisée comme support.

3. Procédé selon la revendication 1 ou 2, **caractérisé en ce que** la tranche est collée sur le support puis est polie pour être ramenée à une épaisseur prédéterminée, l'objet à découper est ensuite coupé en restant collé sur le support, une couche active de la tranche étant collée sur le support.

4. Procédé selon l'une des revendications 1 à 3, **caractérisée en ce qu'**une face inférieure de l'objet à couper est marquée par un laser de marquage.

5. Procédé selon la revendication 1, **caractérisé en ce que** la tranche est collée avec plusieurs puces sur le support par l'intermédiaire de sa face opposée à la face active, le support a la forme d'une plaque, tout particulièrement une plaque parallèle au plan (19), et de préférence, la plaque (19) pour le faisceau laser est conçue en étant transparente, afin de marquer l'objet à couper (30) avec le faisceau laser en traversant celle-ci.

6. Procédé selon la revendication 2, **caractérisé en ce que** le support (3) conçu comme une natte est gardé pour un traitement ultérieur de l'objet à couper grâce à un dispositif de maintien sous vide d'air.

7. Support (3 ; 19) présentant un moyen adhésif pour le procédé selon une des revendications 1 à 6 afin de tenir une tranche à sectionner, respectivement afin de tenir l'objet à couper de la tranche avant, pendant et après le processus de coupe, **caractérisé en ce que** le support (3 ; 19) est conçu de manière à soutenir la tranche (1 ; 21) respectivement l'objet à couper, posé dessus et fixé par le moyen adhésif, et de manière à permettre le retrait ultérieur de l'objet à couper, le support (3 ; 19) étant conçu comme une natte, qui présente un matériau fibreux tissé, respectivement non tissé, transparent relativement au faisceau laser dans le jet liquide (7 ; 27).

8. Support (3 ; 19) selon la revendication 7, **caractérisé en ce qu'**il est tenu, afin d'être protégé contre le fléchissement, respectivement l'affaissement, par au moins un étai placé au dessous, de préférence transparent pour le faisceau du jet liquide laser, translucide en particulier pour l'eau en tant que liquide du jet liquide laser, le matériau de l'étai étant un verre à pores ouverts (par exemple une plaque de verre traitée photochimiquement pour la perforation), en particulier une mousse de verre, de préférence une céramique frittée, de préférence un verre fritté.

9. Support (3 ; 19) selon la revendication 7 ou 8, **caractérisé en ce que** la natte est conçue de façon à être souple grâce à un matériau fibreux extensible.

10. Support (3) selon l'une des revendications 7 à 9, **caractérisé en ce que** la natte (3) est constituée d'un matériau fibreux tissé (woven), le matériau fibreux étant du polyuzéthane, de préférence du polypropylène, tout particulièrement du polyéthylène, de préférence du PET.

11. Support (3) selon l'une des revendications 7 à 9, **caractérisé en ce que** la natte (3) est constituée d'un matériau fibreux non tissé (non-woven), le matériau fibreux étant du polyuréthane, de préférence du polypropylène, tout particulièrement du polyéthylène, de préférence du PET.
